# EUROPÄISCHE PATENTANMELDUNG

(11) **EP 1 675 189 A2**
(43) Veröffentlichungstag der Anmeldung: **28.06.2006**
(21) Anmeldenummer: 05026485.2
(22) Anmeldetag: 05.12.2005
(51) Int. Cl.: H01L 33/00

(54) **Verfahren zur Herstellung eines Halbleiterchips**

(30) Priorität: 23.12.2004 DE 102004062290
(71) Anmelder: Osram Opto Semiconductors GmbH, 93049 Regensburg (DE)
(72) Erfinder: Brüderl, Georg, 93133 Burglengenfeld (DE); Härle, Volker, 93164 Laaber (DE)
(74) Vertreter: Epping - Hermann - Fischer

(57) **Zusammenfassung**

Bei einem Verfahren zur Herstellung eines Halbleiterchips wird eine funktionelle Halbleiterschichtenfolge (2) epitaktisch auf ein Aufwachssubstrat (1) aufgewachsen. Nachfolgend wird eine parallel zu einer Hauptfläche (8) des Aufwachssubstrats (1) liegende Trennzone (4) im Aufwachssubstrat (1) durch Ionenimplantation ausgebildet, wobei die Ionenimplantation durch die funktionelle Halbleiterschichtenfolge (2) hindurch erfolgt. Nachfolgend wird ein Trägersubstrat (6) auf die funktionelle Halbleiterschichtenfolge (2) aufgebracht und ein von der Trennzone (4) aus gesehen von dem Trägersubstrat (6) abgewandter Teil des Aufwachssubstrats (1) entlang der Trennzone (4) abgetrennt.

## Beschreibung

Die Erfindung betrifft ein Verfahren zur Herstellung eines Halbleiterchips, insbesondere eines optoelektronischen Halbleiterchips, nach dem Oberbegriff des Patentanspruchs 1.

Diese Patentanmeldung beansprucht die Priorität der deutschen Patentanmeldung 10 2004 062 290.6, deren Offenbarungsgehalt hiermit durch Rückbezug aufgenommen wird.

Halbleiterbauelemente auf der Basis von Nitridverbindungshalbleitern werden vorwiegend in der Ottoelektronik verwendet, insbesondere zur Strahlungserzeugung im ultravioletten, blauen und grünen Spektralbereich. "Auf Nitridverbindungshalbleitern basierend" bedeutet im folgenden, dass ein derart bezeichnetes Bauelement oder Teil eines Bauelements vorzugsweise InₓAl_{y}Ga_{1-x-y}N umfasst, wobei 0 ≤ x ≤ 1, 0 ≤ y ≤ 1 und x+y ≤ 1 gilt. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Zur Herstellung von auf Nitridverbindungshalbleitern basierenden Halbleiterbauelementen werden üblicherweise Epitaxieverfahren herangezogen. Da eine Reduzierung der Defektdichte im Nitridverbindungshalbleiter eine der Hauptvoraussetzungen für die Erhöhung des internen Wirkungsgrades von auf Nitridverbindungshalbleitern basierenden optoelektronischen Halbleiterchips ist, ist es wünschenswert, ein Aufwachssubstrat zu verwenden, das wie die epitaktisch aufzuwachsende Schichtenfolge aus einem Nitridverbindungshalbleiter gebildet ist. Substrate aus einem Nitridverbindungshalbleiter, insbesondere GaN, sind allerdings nur mit hohem technischen Aufwand herstellbar und daher deutlich teurer als die üblicherweise verwendeten alternativen Substrate aus SiC und Saphir.

Ein bekanntes Herstellungsverfahren optoelektronischer Bauelemente auf der Basis von Nitridverbindungshalbleitern basiert auf der sogenannten Dünnfilm-Technologie. Dabei wird eine funktionelle Halbleiterschichtenfolge zunächst epitaktisch auf einem Aufwachssubstrat aufgewachsen, anschließend ein neuer Träger auf die dem Aufwachssubstrat gegenüberliegende Oberfläche der Halbleiterschichtenfolge aufgebracht und nachfolgend das Aufwachssubstrat abgetrennt. Dies hat insbesondere den Vorteil, dass das Aufwachssubstrat wiederverwendet werden kann. Das Ablösen eines Aufwachssubstrats aus Saphir von einer Halbleiterschichtenfolge aus einem Nitridverbindungshalbleiter kann beispielsweise mit einem aus der WO 98/14986 bekanntem Laser-Lift-Off-Verfahren erfolgen. Dieses Verfahren ist allerdings nicht ohne weiteres auf Substrate aus einem Nitridverbindungshalbleiter anwendbar.

Der Erfindung liegt die Aufgabe zugrunde, ein verbessertes Verfahren zur Herstellung eines Halbleiterchips, vorzugsweise eines auf einem Nitridverbindungshalbleiter basierenden optoelektronischen Halbleiterchips, anzugeben. Vorteilhaft soll die Möglichkeit zur Wiederverwendung des Aufwachssubstrats bestehen und der Herstellungsaufwand vergleichsweise gering sein.

Diese Aufgabe wird durch ein Verfahren nach Patentanspruch 1 gelöst. Vorteilhafte Ausgestaltungen und Weiterbildungen der Erfindung sind Gegenstand der abhängigen Ansprüche.

Bei einem erfindungsgemäßen Verfahren zur Herstellung eines Halbleiterchips, insbesondere eines optoelektronischen Halbleiterchips, wird ein Aufwachssubstrat bereitgestellt und nachfolgend eine funktionelle Halbleiterschichtenfolge auf das Aufwachssubstrat aufgewachsen. Nachfolgend wird eine parallel zu einer Hauptfläche des Aufwachssubstrats liegende Trennzone im Aufwachssubstrat durch Ionenimplantation ausgebildet, wobei die Ionenimplantation durch die funktionelle Halbleiterschichtenfolge hindurch erfolgt. Auf die funktionelle Halbleiterschichtenfolge wird nachfolgend ein Trägersubstrat aufgebracht. In einem weiteren Verfahrensschritt wird schließlich ein von der Trennzone aus gesehen von dem Trägersubstrat abgewandter Teil des Aufwachssubstrats entlang der Trennzone abgetrennt.

Das Aufwachssubstrat ist nach dem Verfahrensschritt des Abtrennens entlang der Trennzone vorteilhaft für die Herstellung weiterer optoelektronischer Bauelemente verwendbar. Dadurch wird der Herstellungsaufwand vermindert.

Da die Ionenimplantation in das Aufwachssubstrat erst nach dem epitaktischen Aufwachsen der funktionellen Halbleiterschichtenfolge auf das Aufwachssubstrat erfolgt, ist sichergestellt, dass die Qualität der epitaktisch aufgewachsenen Schichten nicht durch Mängel der Oberfläche des Aufwachssubstrats beeinträchtigt wird. Derartige Mängel könnten ansonsten entstehen, wenn die Ionenimplantation vor dem Aufbringen der funktionellen Halbleiterschichtenfolge erfolgen würde.

Durch eine gute Gitteranpassung der epitaktisch aufgewachsenen Schichten zum Aufwachssubstrat wird die Defektdichte in der epitaktisch aufgewachsenen funktionellen Halbleiterschichtenfolge vorteilhaft vermindert. Das Aufwachssubstrat und die funktionelle Halbleiterschichtenfolge weisen vorzugsweise eine im wesentlichen gleiche Gitterkonstante auf. Besonders bevorzugt basieren das Aufwachssubstrat und die funktionelle Halbleiterschichtenfolge auf dem gleichen Halbleitermaterial. Insbesondere ist vorgesehen, dass das Aufwachssubstrat und und die funktionelle Halbleiterschichtenfolge jeweils aus einem Nitridverbindungshalbleitermaterial gebildet sind. Die Bezeichnung Nitridverbindungshalbleiter umfasst insbesondere InₓAl_{y}Ga_{1-x-y}N, wobei 0 ≤ x ≤ 1, 0 ≤ y ≤ 1 und x+y ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (A1, Ga, In, N), auch wenn diese teilweise durch geringe Mengen weiterer Stoffe ersetzt sein können.

Das Abtrennen des Aufwachssubstrats entlang der Trennzone erfolgt vorzugsweise durch thermisches Absprengen. Das Ausbilden einer Trennzone durch Ionenimplantation und das thermische Absprengen eines Teils des Substrats ist im Prinzip aus den Druckschriften US 5,374,564 und US 6,103,597 bekannt und wird daher an dieser Stelle nicht näher erläutert.

Bei einer bevorzugten Ausführungsform der Erfindung enthält die funktionelle epitaktische Halbleiterschichtenfolge eine strahlungsemittierende aktive Schicht, die insbesondere InₓAl_{y}Ga_{1-x-y}N mit 0 ≤ x ≤ 1, 0 ≤ y ≤1 und x + y ≤ 1 aufweist.

Nach der Ionenimplantation erfolgt vorzugsweise ein thermisches Ausheilen der epitaktischen funktionellen Halbleiterschichtenfolge, um eine mögliche Beeinträchtigung der Schichtqualität, die aufgrund der durch die funktionelle Halbleiterschichtenfolge erfolgenden Ionenimplantation auftreten könnte, zu vermindern. Insbesondere ist das nachträglich Ausheilen der funktionellen Halbleiterschichtenfolge vorteilhaft mit einem geringeren technischen Aufwand verbunden, als eine Nachbearbeitung des Aufwachssubstrats durch Schleifen oder Ätzen, die im Falle der Ionenimplantation vor dem Aufwachsen der funktionellen Halbleiterschichtenfolge zur Herstellung einer für die Epitaxie geeignete Oberfläche erforderlich wäre. Das thermische Ausheilen muss nicht unmittelbar nach der Ionenimplantation erfolgen, sondern kann insbesondere auch erst nach dem Abtrennen des Teils des Aufwachsubstrats erfolgen, wenn beispielsweise ein thermisches Absprengen bereits bei einer geringeren als der für den Ausheilprozess erforderlichen Temperatur erfolgen würde.

Die epitaktische Halbleiterschichtenfolge wird bevorzugt vor dem Aufbringen des Trägersubstrats mit einer elektrischen Kontaktschicht oder mit einer Kontaktschichtenfolge, die mehrere Einzelschichten umfasst, versehen. Besonders vorteilhaft ist die elektrische Kontaktschicht oder Kontaktschichtenfolge reflektierend oder umfasst eine reflektierende Schicht. Dies ist insbesondere vorteilhaft für strahlungsemittierende optoelektronische Halbleiterchips, da die reflektierende Schicht in die Richtung des Trägersubstrats emittierte Strahlung zu einer dem Trägersubstrat gegenüberliegenden Strahlungsauskopplungsfläche zurückreflektiert und somit eine Absorption im Trägersubstrat verhindert.

Das Aufwachssubstrat ist bevorzugt ein GaN-Substrat oder ein AlN-Substrat. Vorzugsweise ist das Aufwachssubstrat n-dotiert.

Bei der Ionenimplantation werden bevorzugt Wasserstoffionen in das Aufwachssubstrat implantiert. Alternativ können auch Ionen von Edelgasen wie beispielsweise Helium, Neon, Krypton oder Xenon verwendet werden.

Das Trägersubstrat weist vorteilhaft einen thermischen Ausdehnungskoeffizienten auf, der an den thermischen Ausdehnungskoeffizienten der auf einem Nitridverbindungshalbleiter basierenden funktionellen Halbleiterschichtenfolge angepasst ist. Dies hat den Vorteil, dass eine Beschädigung der funktionellen Halbleiterschichtenfolge durch mechanische Spannungen, die bei stark unterschiedlichen thermischen Ausdehnungskoeffizienten der funktionellen Halbleiterschichtenfolge und des Trägersubstrats insbesondere bei einer für das thermische Absprengen des Aufwachssubstrats erforderlichen Erhitzung des Halbleiterchips auftreten könnte, verhindert.

Besonders geeignete Materialien für das Trägersubstrat sind Ge, GaAs, Metalle wie beispielsweise Mo oder Au, oder Metalllegierungen auf der Basis von Au oder Mo. Das Trägersubstrat wird vorzugsweise mittels Löten oder Bonden auf die funktionelle Halbleiterschichtenfolge oder gegebenenfalls auf die Kontaktschicht- oder Schichtenfolge aufgebracht. Insbesondere können Bonding-Verfahren wie Waferbonden, eutektisches Bonden oder oxidisches Bonden eingesetzt werden.

Bevorzugt wird das Verfahren gemäß der Erfindung zur Herstellung optoelektronischer Halbleiterchips, insbesondere für Lumineszenzdioden und Halbleiterlaserbauelemente, verwendet. Alternativ kann es auch bei der Herstellung anderer elektronischer Bauelemente verwendet werden.

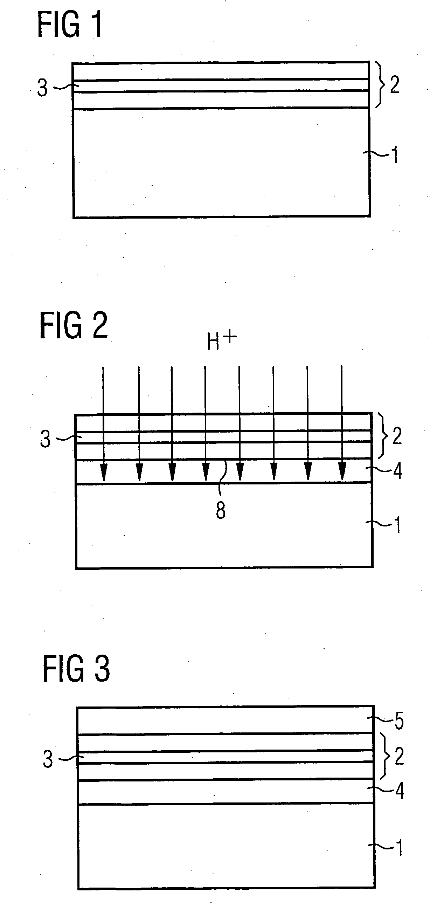

Das erfindungsgemäße Verfahren wird im folgenden anhand eines Ausführungsbeispiels im Zusammenhang mit den Figuren 1 bis 6 näher erläutert.

Die Figuren 1 bis 6 zeigen jeweils schematisch dargestellte Querschnitte eines optoelektronischen Halbleiterchips bei Zwischenschritten eines Ausführungsbeispiels des erfindungsgemäßen Verfahrens.

Gleiche oder gleichwirkende Elemente sind in den Figuren mit den gleichen Bezugszeichen versehen.

Bei dem in Figur 1 dargestellten Zwischenschritt eines Ausführungsbeispiels eines erfindungsgemäßen Verfahrens ist eine funktionelle Halbleiterschichtenfolge 2, die auf einem Nitridverbindungshalbleiter basiert, auf ein aus einem Nitridverbindungshalbleiter bestehendes Aufwachssubstrat 1 aufgebracht. Das Aufwachssubstrat 1 kann insbesondere ein GaN-Substrat oder ein AlN-Substrat sein. Vorzugsweise ist das Aufwachssubstrat 1 ein n-dotiertes Substrat. Die funktionelle Halbleiterschichtenfolge 2 kann insbesondere eine strahlungsemittierende aktive Zone 3 enthalten, die beispielsweise InₓAl_{y}Ga_{1-x-y}N mit 0≤x≤1, 0≤y≤1 und x+y≤1 enthält. Die funktionelle Halbleiterschichtenfolge 2 wird beispielsweise mittels metallorganischer Gasphasenepitaxie (MOVPE) oder einem anderen epitaktischen Herstellungsverfahren aufgebracht.

Bei dem in der Figur 2 dargestellten Zwischenschritt wird durch Implantation von H⁺-Ionen eine parallel zu einer Hauptfläche 8 des Aufwachssubstrats 1 verlaufende Trennzone 4 in dem Aufwachssubstrat 1 ausgebildet. Die H⁺-Ionen werden dabei durch die funktionelle Halbleiterschichtenfolge 2, die beispielsweise die aktive Schicht 3 enthält, hindurch in das Aufwachssubstrat 1 implantiert. Nach der Ionenimplantation erfolgt vorzugsweise eine Temperaturbehandlung der funktionellen Halbleiterschichtenfolge 2, um durch die hochenergetischen Ionen möglicherweise hervorgerufene Schädigungen der funktionellen Halbleiterschichtenfolge 2 zu vermindern.

Bei dem in Figur 3 dargestellten Zwischenschritt wurde eine Kontaktschicht 5 auf die funktionelle Halbleiterschichtenfolge 2 aufgebracht. Die Kontaktschicht 5 ist vorzugsweise reflektierend für die von der strahlungsemittierenden aktiven Zone 3 emittierte Strahlung. Insbesondere kann die Kontaktschicht 5 auch mehrlagig ausgeführt sein, wobei sie vorzugsweise auf einer der funktionellen Halbleiterschichtenfolge 2 zugewandten Seite eine reflektierende Schicht, die beispielsweise Au, AuGe, Ag, Al oder ein anderes Metall oder eine andere Metallverbindung enthält, umfasst. Derartige Kontaktschichten sind beispielsweise aus der DE 103 50 707 A1 bekannt und werden daher an dieser Stelle nicht näher erläutert.

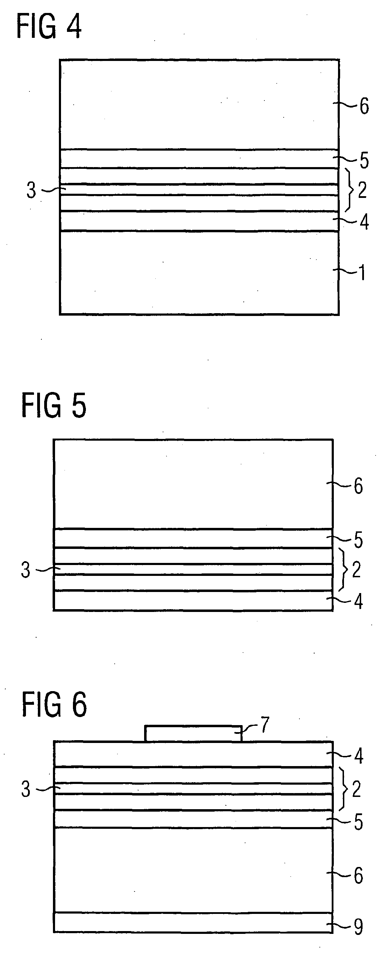

Bei dem in Figur 4 dargestellten Zwischenschritt des erfindungsgemäßen Verfahrens wurde auf die mit der Kontaktschicht 5 versehene Halbleiterschichtenfolge 2 ein Trägersubstrat 6 aufgebracht. Das Aufbringen des Trägersubstrats 6 erfolgt vorzugsweise durch Bonden oder Löten. Vorteilhaft besteht das Trägersubstrat 6 im wesentlichen aus Ge, GaAs, Mo oder Au. Diese Materialien haben den Vorteil einer guten Anpassung ihres thermischen Ausdehnungskoeffizienten an den thermischen Ausdehnungskoeffizienten der funktionellen Halbleiterschichtenfolge 2, die auf einem Nitridverbindungshalbleiter basiert. Dadurch werden mechanische Spannungen zwischen dem Trägersubstrat 6 und der Halbleiterschichtenfolge 2 beim nachfolgenden Verfahrensschritt des thermischen Absprengens des Aufwachssubstrats 1, bei dem der Halbleiterchip stark erhitzt werden muss, vorteilhaft vermindert und somit der Ausbildung von Rissen und/oder einem Ablösen des Trägersubstrats 6 von der Halbleiterschichtenfolge 2 entgegengewirkt.

Bei dem in der Figur 5 dargestellten Zwischenschritt wurde der auf der von dem Trägersubstrat 6 abgewandten Seite der Trennzone 4 liegende Teil des Aufwachssubstrats 1 thermisch abgesprengt, beispielsweise durch Erhitzen auf eine Temperatur von etwa 300 °C bis 700 °C. Somit verbleibt nur noch die vorzugsweise sehr dünne Trennzone 4 auf der Halbleiterschichtenfolge 2. Die Dicke der Trennzone 4, die nach dem Absprengen des ursprünglichen Aufwachssubstrats 1 mit der funktionellen Halbleiterschichtenfolge 2 verbunden bleibt, kann vermindert werden, in dem die Energie der Wasserstoffionen bei der Ionenimplantation derart gewählt wird, dass das Maximum ihrer Verteilung möglichst nah an der Grenzfläche zwischen dem ursprünglichen Aufwachssubstrat 1 und der funktionellen Halbleiterschichtenfolge 2 auftritt.

Bei dem in Figur 6 dargestellten Zwischenschritt wurde eine erste Kontaktmetallisierung 7, die vorzugsweise den n-Kontakt des Halbleiterchips ausbildet, auf die von dem Trägersubstrat 6 abgewandte Seite des Halbleiterchips und eine zweite Kontaktmetallisierung 9, die vorzugsweise den p-Kontakt des Halbleiterchips ausbildet, auf die von der Halbleiterschichtenfolge 2 abgewandte Seite des Trägersubstrats 6 aufgebracht. Selbstverständlich kann auch die umgekehrte Polarität vorliegen und es können auch andere dem Fachmann bekannte Kontaktierungstechniken verwendet werden. Insbesondere muss das Trägersubstrat 6 nicht elektrisch leitend sein, sondern es können auch sowohl der n-Kontakt als auch der p-Kontakt auf der der Halbleiterschichtenfolge 2 zugewandten Seite des Trägersubstrats 6 vorgesehen sein.

Die Beschreibung des Verfahrens anhand der in den Figuren 1 bis 6 gezeigten Zwischenschritte kann selbstverständlich durch weitere Verfahrensschritte ergänzt werden. Beispielsweise kann die funktionelle Halbleiterschichtenfolge 2 schon vor dem Aufbringen des Trägersubstrats 6 in eine Mehrzahl einzelner Halbleiterschichtstapel strukturiert werden. Nach dem Aufbringen des Trägersubstrats 6 kann die Mehrzahl der Halbleiterschichtstapel dann beispielsweise durch Sägen oder Brechen in einzelne Halbleiterchips vereinzelt werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung eines Halbleiterchips, der eine epitaktisch hergestellte funktionelle Halbleiterschichtenfolge (2) aufweist, das folgende Verfahrensschritte umfasst:
- Bereitstellen eines Aufwachssubstrats (1),
- Epitaktisches Aufwachsen der funktionellen Halbleiterschichtenfolge (2) auf das Aufwachssubstrat (1),
- Ausbilden einer parallel zu einer Hauptfläche (8) des Aufwachssubstrats (1) liegenden Trennzone (4) im Aufwachssubstrat (1) durch Ionenimplantation, wobei die Ionenimplantation in das Aufwachssubstrat (1) dem epitaktischen Aufwachsen nachfolgt und durch die funktionelle Halbleiterschichtenfolge (2) hindurch erfolgt,
- Aufbringen eines Trägersubstrats (6) auf die funktionelle Halbleiterschichtenfolge (2), und
- Abtrennen eines von der Trennzone(4) aus gesehenen von dem Trägersubstrat (6) abgewandten Teils des Aufwachssubstrats (1) entlang der Trennzone (4).

2. Verfahren nach Anspruch 1,
**dadurch gekennzeichnet, dass**
das Aufwachssubstrat (1) und die funktionelle Halbleiterschichtenfolge (2) im wesentlichen die gleiche Gitterkonstante aufweisen.

3. Verfahren nach Anspruch 1 oder 2,
**dadurch gekennzeichnet, dass**
das Aufwachssubstrat (1) und die funktionelle Halbleiterschichtenfolge (2) auf dem gleichen Halbleitermaterial basieren.

4. Verfahren nach Anspruch 3,
**dadurch gekennzeichnet, dass**
das Aufwachssubstrat und (1) und die funktionelle Halbleiterschichtenfolge (2) jeweils aus einem Nitridverbindungshalbleitermaterial gebildet sind.

5. Verfahren nach einem der vorhergehenden Ansprüche,
**dadurch gekennzeichnet, dass**
die funktionelle Halbleiterschichtenfolge (2) eine strahlungsemittierende aktive Schicht (3) enthält, die InₓAl_{y}Ga_{1-x-y}N mit 0 ≤ x ≤ 1, 0 ≤ y ≤ 1 und x+y ≤ 1, aufweist.

6. Verfahren nach einem der vorhergehenden Ansprüche,
**dadurch gekennzeichnet, dass**
das Aufwachssubstrat (1) ein GaN-Substrat oder ein AlN-Substrat ist.

7. Verfahren nach einem der vorhergehenden Ansprüche,
**dadurch gekennzeichnet, dass**
das Abtrennen des von der Trennzone(4) aus gesehenen von dem Trägersubstrat (6) abgewandten Teil des Aufwachssubstrats (1) entlang der Trennzone (4) durch thermisches Absprengen erfolgt.

8. Verfahren nach einem der vorhergehenden Ansprüche,
**dadurch gekennzeichnet, dass**
das Aufwachsubstrat (1) ein elektrisch leitfähiges Substrat, insbesondere ein n-leitendes Substrat, ist.

9. Verfahren nach einem der vorhergehenden Ansprüche,
**dadurch gekennzeichnet, dass**
das Trägersubstrat (6) ein elektrisch leitfähiges Substrat, insbesondere ein p-leitendes Substrat, ist.

10. Verfahren nach einem der vorhergehenden Ansprüche,
**dadurch gekennzeichnet, dass**
bei der Ionenimplantation Wasserstoffionen implantiert werden.

11. Verfahren nach einem der vorhergehenden Ansprüche,
**dadurch gekennzeichnet, dass**
nach der Ionenimplantation ein thermisches Ausheilen der funktionellen Halbleiterschichtenfolge (2) erfolgt.

12. Verfahren nach einem der vorhergehenden Ansprüche,
**dadurch gekennzeichnet, dass**
die funktionelle Halbleiterschichtenfolge (2) vor dem Aufbringen des Trägersubstrats (6) mit einer elektrischen Kontaktschicht oder -schichtenfolge (5) versehen wird.

13. Verfahren nach Anspruch 12,
**dadurch gekennzeichnet, dass**
die funktionelle Halbleiterschichtenfolge (2) eine strahlungsemittierende aktive Schicht (3) umfasst und die elektrische Kontaktschicht (5) als Reflektor für die emittierte Strahlung dient.
